(19) Europäisches Patentamt / European Patent Office / Office européen des brevets

(11) **EP 4 648 283 A1**

(12) # DEMANDE DE BREVET EUROPEEN

(43) Date de publication:
**12.11.2025 Bulletin 2025/46**

(21) Numéro de dépôt: **25172692.3**

(22) Date de dépôt: **25.04.2025**

(51) Classification Internationale des Brevets (IPC):
**H03K 5/135** (2006.01)   **H03K 5/15** (2006.01)
**H03K 3/03** (2006.01)

(52) Classification Coopérative des Brevets (CPC):
**H03K 5/135; H03K 5/1502; H03K 5/15093;**
H03K 3/0315

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH LA MA MD TN**

(30) Priorité: **03.05.2024 FR 2404687**

(71) Demandeur: **STMicroelectronics International N.V.**
**1228 Plan-les-Ouates, Geneva (CH)**

(72) Inventeur: **JOUANNEAU, Thomas**
**38560 Jarrie (FR)**

(74) Mandataire: **Cabinet Beaumont**
**4, Place Robert Schuman**
**B.P. 1529**
**38025 Grenoble Cedex 1 (FR)**

(54) **DISPOSITIF DE GÉNÉRATION DE SÉQUENCE TEMPORELLE**

(57) La présente description concerne un dispositif (200) comprenant un oscillateur en anneau (RO) comprenant une pluralité de portes (Il, INf) fournissant chacune un signal d'horloge rapide (CKfl, CkfNf). Un premier registre à décalage (OSC) comprend une succession de premières bascules (FFsl, FFsNS) synchronisées chacune sur un même premier signal d'horloge (CKl) correspondant à un des signaux d'horloge rapides (CKfl, CkfNf). Le premier registre à décalage (OSC) est rebouclé sur lui-même et met en œuvre un deuxième oscillateur où chaque première bascule (FFsl, FFsNs) fournit un signal d'horloge lent (CKs1, CKsNs). Un deuxième registre à décalage (SR) comprend une succession de deuxièmes bascules (FF1, FFNdl) chacune synchronisée sur un même deuxième signal d'horloge (CKs) correspondant à l'un des signaux d'horloge lents (CKs1, CKsNs).

Fig 2

EP 4 648 283 A1

## Description

Domaine technique

La présente description concerne de façon générale des circuits électroniques de génération de signaux numériques temporels.

Technique antérieure

De nombreux types de dispositifs, comme les mémoires ou les calculateurs, nécessitent des signaux numériques avec des séquences temporelles données pour commander des actions, à réaliser par ces dispositifs et à des moments précis.

Il est connu de la personne du métier de générer de telles séquences temporelles avec une échelle de temps de l'ordre de quelques centaines de picosecondes en utilisant un microprocesseur à une fréquence de fonctionnement de plusieurs GHz. Ce microprocesseur utilise en général des systèmes à boucles de phase fermées (Phase Lock Loop en anglais) à des fréquences importantes, ce qui implique l'utilisation de technologies avancées ainsi que des coûts de fabrication et une consommation élevés. Il est en outre actuellement difficile de générer de telles séquences temporelles ajustables sans impliquer une complexité de développement importante.

Pour générer de telles séquences temporelles ajustables, les documents FR 3133458, US 2023291396 et CN 116760392 décrivent un dispositif comprenant un oscillateur en anneau et un registre à décalage synchronisé sur un signal d'horloge fourni par l'une des portes logiques de l'oscillateur en anneau.

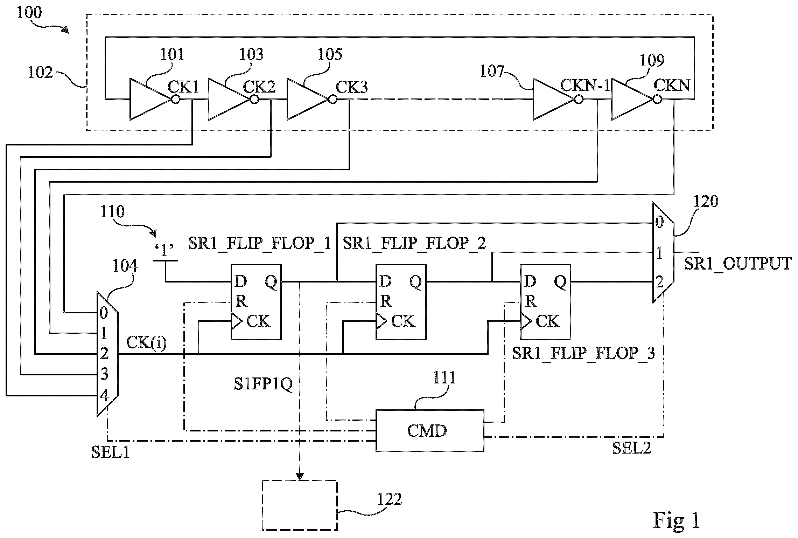

La figure 1 est une reproduction de la figure 1 des documents mentionnés ci-dessus. La figure 1 représente, de manière schématique, un exemple de circuit 100 de génération de front d'une séquence temporelle.

Selon l'exemple de la figure 1, le circuit 100 de génération de séquence temporelle comprend un oscillateur en anneau 102. L'oscillateur en anneau 102 est composé d'une pluralité de portes logiques 101, 103, 105, 107, 109 reliées en série et avec la sortie de la porte logique 109 reliée à l'entrée de la porte logique 101, et dont le nœud de sortie respectif est nommé CK1, CK2, CK3, CKN-1, CKN. En utilisant le chiffre N, qui représente le nombre de portes logiques de l'oscillateur, la personne du métier pourra ajuster ses calculs en fonction du nombre de portes idoine. Dans l'exemple de la figure 1, les portes logiques sont, par exemple, des inverseurs. Il est toutefois possible que l'oscillateur 102 soit formé à partir d'autres types de portes logiques, tels que des portes NON-OU ("NOR" en anglais) ou des portes NON-ET ("NAND" en anglais).

L'oscillateur 102 est implémenté, par exemple, par une boucle composée d'un nombre impair de portes logiques inverseuses. Même si dans l'exemple de la figure 1, cinq portes sont illustrées, il est par exemple possible que l'oscillateur soit implémenté par trois portes logiques ou bien encore par un nombre de portes logiques impair supérieur à cinq. Chaque porte logique fournit un signal d'horloge en sortie : CK1, CK2, CK3, CKN-1, et CKN.

Les signaux d'horloge en sortie CK1 à CKN ont des fronts présentant des décalages temporels les uns par rapport aux autres, et en sélectionnant l'un parmi ces signaux, il est ainsi possible de générer un front avec un décalage temporel donné. Par exemple, en prenant comme premier signal le signal CK1, le signal CK3 est en retard par rapport au signal CK1, le signal CKN, c'est à dire le signal CK5 dans l'exemple de la figure 1, est en retard par rapport au signal CK3, le signal CK2 est en retard par rapport au signal CKN, et le signal CKN-1, c'est à dire le signal CK4 dans l'exemple de la figure 1, est en retard par rapport au signal CK2.

Les signaux d'horloge CK1, CK2, CK3, CKN-1 et CKN sont, par exemple, reliés à l'entrée d'un multiplexeur 104 configuré pour sélectionner un ou plusieurs signaux parmi ces signaux d'horloge. Le multiplexeur 104 est commandé par un signal de sélection SEL1 généré par une unité de commande CMD, 111. La sortie du multiplexeur 104 alimente une entrée de signal d'horloge d'un premier registre à décalage 110 avec un signal d'horloge CK(i) sélectionné parmi les signaux d'horloge CK1 à CKN, avec i un indice entier allant de 0 à N-1. Dit autrement, le registre à décalage 110 est synchronisé sur l'un des signaux CK(i).

Selon l'exemple de la figure 1, le premier registre à décalage 110 comprend trois bascules SR1_FLIP_FLOP_1, SR1_FLIP_FLOP_2, SR1_FLIP_FLOP_3 reliées en série. Il est toutefois possible d'envisager, selon le décalage temporel souhaité, que le registre à décalage 110 ne comprenne qu'une seule bascule ou deux bascules ou bien un nombre de bascules reliées en série supérieur à trois. Dans l'exemple de la figure 1, les bascules sont par exemple de type D. Dans la suite de la description, des exemples sont décrits dans lesquels les bascules sont activées par des fronts montants. Cependant, la personne du métier saura adapter l'enseignement de la description pour des bascules à activation par front descendant. Par les termes « reliées en série » on entend que la sortie d'une bascule, notée Q, est reliée à l'entrée de donnée, notée D, de la bascule suivante dans la série. La personne du métier saura également adapter le circuit en considérant une sortie $\overline{Q}$ des bascules, la sortie $\overline{Q}$ d'une bascule correspondant au complément binaire de la sortie Q de cette bascule. L'entrée de donnée D de la première bascule SR1_FLIP_FLOP_1 de la série de bascules est, par exemple, alimentée par une tension à l'état haut, notée '1'.

L'entrée de signal d'horloge du premier registre à décalage 110 est reliée, par exemple, à l'entrée d'horloge, notée CK, de chacune des bascules de la série.

Le signal de sortie de chacune des bascules est, par exemple, relié à un multiplexeur 120 qui permet de sélectionner l'un parmi les signaux de sortie Q des bascules pour former un signal de sortie SR1_OUTPUT du registre à décalage 110. Dans l'exemple de la figure 1, le front montant du signal de sortie sélectionné par le multiplexeur 120 constitue le front montant de la séquence temporelle à obtenir. Le multiplexeur 120 est, par exemple, commandé par un signal SEL2 généré par l'unité de commande CMD. Cela permet la génération de séquences temporelles aisément ajustables. Dans d'autres modes de réalisation, le multiplexeur 120 est omis.

Dans certains modes de réalisation, le signal de sortie de la première bascule, noté S1FP1Q, est dirigé vers un circuit secondaire 122.

Les entrées de remise à zéro (RESET en anglais), notées R, de chacune des bascules SR1_FLIP_FLOP_1, SR1_FLIP_FLOP_2, SR1_FLIP_FLOP_3 sont, par exemple, commandées par l'unité de commande CMD. L'unité de commande CMD est par exemple configurée pour commander ces entrées de remise à zéro pour que la remise à zéro des bascules soit faite avant le commencement du cycle de génération de la séquence temporelle.

La sélection d'un des signaux d'horloge avec le multiplexeur 104 du circuit de la figure 1 permet de générer un front dans une plage de temps égale ou proche du front de la séquence de temps à obtenir. De façon complémentaire, le front produit avec la sélection du signal d'horloge voulu par le multiplexeur 104 est potentiellement décalable d'un nombre de périodes d'horloge au maximum égal au nombre de bascules du premier registre à décalage 110. Le nombre de bascules sera donc implémenté en fonction de la durée de la séquence temporelle recherchée. Dans certains modes de réalisation, au sein d'un dispositif, plusieurs circuits de génération de front de séquence temporelle 100 sont, par exemple, implémentés avec chacun un nombre de bascules du premier registre qui est le même, ou qui est différent pour au moins certains des circuits par rapport aux autres, le nombre de bascules étant par exemple choisi pour être égal à un décalage de front maximal. Les multiplexeurs 104 et/ou 120 permettent de programmer ce décalage pour générer des séquences temporelles de durée différente.

Le circuit 100 de la figure 1 permet de générer une séquence temporelle avec un front avec un nombre plus faible de bascules par rapport à d'autres solutions. Le ratio puissance par unité de surface peut être diminué de plus de la moitié par rapport à des solutions existantes. De plus, l'exemple de la figure 1 permet de ne pas augmenter exponentiellement la complexité de conception avec la durée de la séquence temporelle à générer. En effet, générer un front de la séquence temporelle avec un décalage supplémentaire peut être effectué en ajoutant un circuit 100 supplémentaire avec un nombre de bascules choisi en fonction du décalage temporel souhaité.

Plus particulièrement, dans le dispositif 100 de la figure 1 où N est égal à 5, on renomme les signaux CK1 à CKN dans l'ordre du décalage temporel qu'il y a entre eux. Ainsi, CK(0)=CK1, CK(1)=CK3, CK(2)=CK5, CK(3) =CK2 et CK(4)=CK4. Le délai entre un front du signal CK(i) et le front correspondant, décalé dans le temps, du signal CK(i+1) suivant est alors égal à T/N, avec T la période de l'oscillateur 102. En prenant comme référence un instant t0 correspondant, par exemple, à un front, par exemple montant, du signal CK(0), le front correspondant du signal CK(1) est retardé de T/N secondes par rapport à l'instant t0, le front correspondant du signal CK(2) est retardé de 2*T/N secondes par rapport à l'instant t0, le front correspondant du signal CK(3) est retardé de 3*T/N secondes par rapport à l'instant t0, et le front correspondant du signal CK(4) est retardé de 4*T/N secondes par rapport à l'instant t0.

Ainsi, par rapport à l'instant t0 correspondant, par exemple, à un front, par exemple montant, du signal CK(0), et, par exemple, à une réinitialisation des sorties Q du registre 110, un front, par exemple montant, sur la sortie Q de la bascule SR1_FLIP_FLOP_1 est décalé de i*T/N, avec i allant de 0 à N-1, lorsque le registre à décalage 110 est synchronisé sur le signal CK(i) sélectionné par le multiplexeur 104.

En outre, par rapport à l'instant t0, un front, par exemple montant, correspondant sur la sortie Q de la bascule SR1_FLIP_FLOP2 est décalé d'une période T par rapport au front sur la sortie Q de la bascule SR1_FLIP_FLOP1, et un front, par exemple montant, correspondant sur la sortie Q de la bascule SR1_FLIP_FLOP3 est décalé de deux périodes T par rapport au front sur la sortie Q de la bascule SR1_FLIP_FLOP1.

Le dispositif 100 de la figure 1 permet donc de générer un front avec un retard par rapport à l'instant t0 qui au maximum est égal à (N-1)*T/N + (P-1)*T, avec P le nombre de bascules du registre 110, P étant égal à 3 dans l'exemple de la figure 1. Le pas T/N représente la précision temporelle sur ce délai entre l'instant t0 et le front généré.

A titre d'exemple, pour un oscillateur 102 fonctionnant à une fréquence de 800 MHz et comprenant N=5 portes inverseuses en série, et pour un registre à décalage 110 comprenant M=3 bascules, la résolution temporelle avec laquelle peut être généré un délai donné entre un instant t0 et un front en sortie du multiplexeur 120 est égale à 250 ps. En outre, pour cet exemple, le délai entre l'instant t0 et le front en sortie du multiplexeur 120 est au maximum égal à $4*250.10^{-12} + 2*1,25.10^{-9} = 3,5$ ns.

Un inconvénient du dispositif de la figure 1 est que le nombre de bascules du registre 110 augmente avec la valeur maximale du délai que l'on souhaite atteindre. Par exemple, pour un délai supérieur ou égal à dix fois la période de l'oscillateur 102, le registre 110 doit être mis en œuvre avec au moins dix bascules. Il en résulte que le dispositif devient encombrant et consomme plus d'énergie, ce qui n'est pas souhaitable.

On pourrait penser à modifier la fréquence de l'oscillateur 102. Toutefois, cela est difficile à mettre en œuvre, en particulier en ce qui concerne la stabilité en fréquence de l'oscillateur 102 par rapport aux variations de température. En outre, baisser la fréquence de l'oscillateur 102 pour réduire le nombre de bascules du registre 110 implique de réduire la précision temporelle avec laquelle des délais peuvent être générés par le dispositif 100 du fait que le pas de réglage d'un délai est égal à T/N avec T la période de l'oscillateur 102. Enfin, un dispositif 100 dans lequel la fréquence de l'oscillateur 102 serait modifiable serait complexe à mettre en œuvre.

Résumé de l'invention

Il existe un besoin d'un circuit de génération de séquences temporelles, de préférence aisément ajustables, qui puisse être fabriqué avec des coûts modérés tout en limitant la consommation électrique et la surface du circuit.

Un mode de réalisation pallie tout ou partie des inconvénients des circuits de génération de séquence temporelle connus.

Un mode de réalisation prévoit un dispositif comprenant :

un oscillateur en anneau comprenant une pluralité de portes logiques inverseuses couplées les unes à la suite des autres et fournissant chacune un signal d'horloge rapide ;
un premier registre à décalage comprenant une succession de premières bascules, de préférence de type D, synchronisées chacune sur un même premier signal d'horloge correspondant à un des signaux d'horloge rapides ayant sa fréquence divisée par un entier M strictement positif, le premier registre à décalage étant rebouclé sur lui-même de sorte à mettre en œuvre un deuxième oscillateur dans lequel chaque première bascule fournit un signal d'horloge lent ; et
un deuxième registre à décalage comprenant une unique deuxième bascule ou une succession de deuxièmes bascules, chaque deuxième bascule étant synchronisée sur un même deuxième signal d'horloge correspondant à l'un des signaux d'horloge lents.

Selon un mode de réalisation, une entrée de donnée d'une première première bascule de ladite succession de premières bascules reçoit un signal déterminé au moins en partie par un premier signal binaire égal à un OU logique entre une sortie d'une dernière première bascule de ladite succession de premières bascules et une négation logique d'un OU logique entre des sorties d'au moins deux dernières premières bascules de ladite succession de premières bascules.

Selon un mode de réalisation, le signal reçu par l'entrée de donnée de la première première bascule est égal à un OU logique entre le premier signal et une négation d'un signal d'activation, ou à un ET logique entre le premier signal et le signal d'activation.

Selon un mode de réalisation, les signaux d'horloge rapides sont décalés en temps les uns par rapport aux autres.

Selon un mode de réalisation, les signaux d'horloge lents sont décalés en temps les uns par rapport aux autres.

Selon un mode de réalisation, le dispositif comprend un premier circuit de sélection configuré pour sélectionner le premier signal d'horloge parmi ledit signal d'horloge rapide ayant sa fréquence divisée par l'entier M et au moins un autre des signaux d'horloge rapides.

Selon un mode de réalisation, le premier circuit de sélection est configuré pour fournir le premier signal d'horloge à une entrée de synchronisation de chacune des premières bascules.

Selon un mode de réalisation, le dispositif comprend un deuxième circuit de sélection configuré pour sélectionner le deuxième signal d'horloge parmi tout ou partie des signaux d'horloge lents.

Selon un mode de réalisation, le deuxième circuit de sélection est configuré pour fournir le deuxième signal d'horloge à une entrée de synchronisation de chacune des deuxièmes bascules.

Selon un mode de réalisation, le dispositif comprend un troisième registre à décalage comprenant une unique troisième bascule ou une succession de troisièmes bascules, de préférence de type D, chaque troisième bascule étant synchronisée sur un même troisième signal d'horloge correspondant à un des signaux d'horloge rapides.

Selon un mode de réalisation, le dispositif comprend un troisième circuit de sélection configuré pour recevoir tout ou partie des signaux d'horloge rapides, et pour fournir le troisième signal d'horloge à une entrée de synchronisation de chaque troisième bascule.

Selon un mode de réalisation, une entrée de donnée du troisième registre à décalage reçoit un signal déterminé par une sortie du deuxième registre à décalage.

Selon un mode de réalisation, le deuxième registre à décalage comprend la succession de deuxièmes bascules, et le dispositif comprend un quatrième circuit de sélection configuré pour sélectionner un signal de sortie d'une des deuxièmes bascules parmi tout ou partie des signaux de sortie des deuxièmes bascules, et pour fournir le signal sélectionné à l'entrée de donnée du troisième registre à décalage.

Selon un mode de réalisation, une sortie du troisième registre est une sortie de l'unique troisième bascule ou d'une des troisièmes bascules de la succession de troisièmes bascules, par exemple, sélectionnée par un circuit de sélection parmi tout ou partie des sorties des troisièmes bascules de la succession de troisièmes bascules.

Selon un mode de réalisation, le dispositif comprend un circuit configuré pour :

> commander des initialisations des bascules ; et/ou
> commander une activation du premier oscillateur.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

> la figure 1, décrite précédemment, est une reproduction de la figure 1 des demandes de brevets mentionnées ci-dessus ; et
> la figure 2 représente un exemple de mode de réalisation d'un dispositif de génération d'une séquence temporelle.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures ou à un ... dans une position normale d'utilisation.

Sauf précision contraire, les expressions "environ", "approximativement", "sensiblement", et "de l'ordre de" signifient à 10 % ou à 10° près, de préférence à 5 % ou à 5° près.

Pour pallier aux inconvénients d'un circuit de génération d'une séquence temporelle du type de celui de la figure 1, il est ici proposé un circuit de génération d'une séquence temporelle, par exemple d'un délai entre un instant initial de la séquence et le premier front de la séquence temporelle. Le circuit proposé comprend un oscillateur en anneau similaire à celui du dispositif 100 de la figure 1, un premier registre à décalage rebouclé sur lui-même de sorte à mettre en œuvre un oscillateur, et un deuxième registre à décalage. Le premier registre à décalage est synchronisé sur un signal d'horloge rapide fourni par l'une des portes logiques inverseuses de l'oscillateur en anneau. Le deuxième registre à décalage est synchronisé sur un signal d'horloge lent par rapport au signal d'horloge rapide, ce signal d'horloge lent étant fourni par l'une des bascules du premier registre à décalage.

De préférence, un troisième registre à décalage a une entrée de donnée couplée à une sortie du deuxième registre à décalage, et est synchronisé sur un signal d'horloge rapide fourni par l'une des portes logiques inverseuses de l'oscillateur en anneau.

Dans un tel dispositif, les signaux d'horloge rapides fournis par les portes logiques de l'oscillateur permettent une finesse de réglage d'un délai égale à $Tf/Nf$, avec $Tf$ la période de l'oscillateur en anneau et $Nf$ le nombre de portes logiques inverseuses en série dans l'oscillateur en anneau. En outre, le premier registre à décalage configuré en oscillateur génère des signaux d'horloge lents à une période égal à $Ts = Ns*Tf$, avec $Ns$ le nombre de bascules en série dans le premier registre à décalage. Ainsi, le deuxième registre à décalage permet de générer un délai ayant une valeur maximale égale à $(Nd1-1)*Ts + (Ns-1)*(Ts/Ns)$, avec $Nd1$ le nombre de bascules du deuxième registre à décalage, avec une précision temporelle égale à $Ts/Ns$, donc à $Tf$.

De préférence, lorsque le dispositif comprend le troisième registre à décalage, le dispositif permet de générer un délai correspondant à la somme d'un premier délai fourni par le deuxième registre à décalage, et d'un deuxième délai fourni par le troisième registre à décalage et débutant à partir de la fin du premier délai. Dans ce cas, la précision sur le délai généré par le dispositif est égale à $Tf/Nf$. En outre, le délai généré par le dispositif a une valeur maximale au moins égale à $(Nd1-1)*Ts + (Ns-1)*(Ts/Ns) + (Nd2-1)*Tf$, avec $Nd2$ le nombre de bascules du troisième registre à décalage.

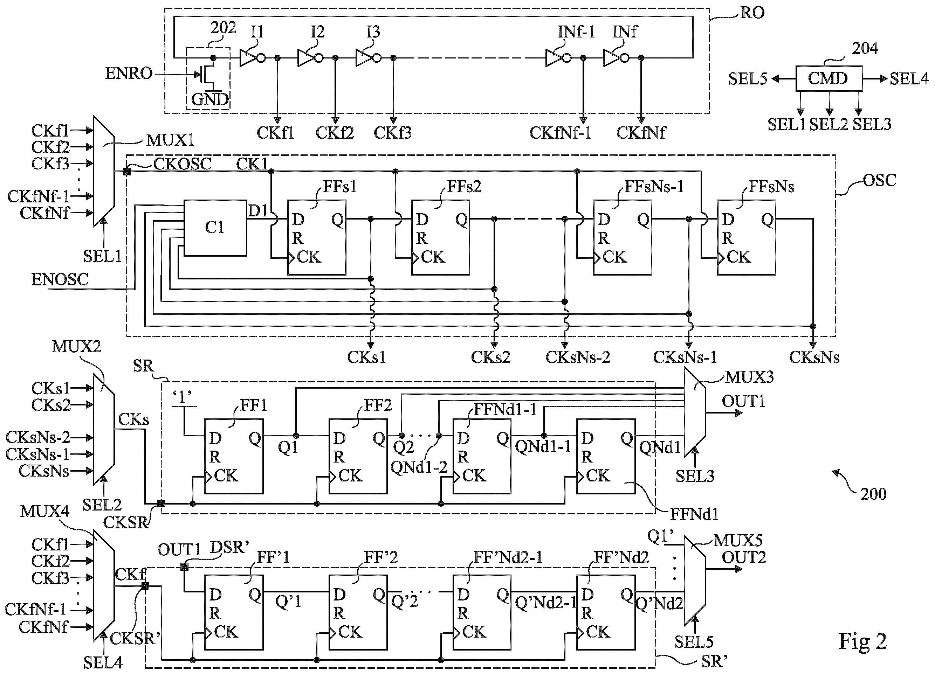

La figure 2 représente un exemple d'un mode de réalisation d'un tel circuit ou dispositif 200 de génération d'une séquence temporelle.

Le dispositif 200 comprend un oscillateur en anneau RO. L'oscillateur en anneau RO est composé d'une pluralité de portes logiques inverseuses $Ii$, avec $i$ un indice allant de 1 à $Nf$ et $Nf$ un entier impair supérieur ou égal à 3. Les portes logiques $Ii$ ($I1$, $I2$, $I3$, ..., $INf-1$ et $INf$ en figure 2) sont reliées en série, ou, dit autrement, les unes à la suite des autres, par exemple par ordre d'indice $i$ croissant dans l'exemple de la figure 2. La sortie de la porte logique $INf$ est couplée, par exemple connectée, à l'entrée de la porte logique $I1$. Dit autrement, l'entrée de la première porte logique $I1$ de la connexion en série des $Nf$ portes $Ii$ est couplée, par exemple connectée, à la sortie de la dernière porte logique $INf$ de la connexion en série des Nf portes Ii.

Par exemple, en figure 2, la sortie de la porte INf est couplée à l'entrée de la porte I1 par un circuit 202 configuré pour sélectivement activer et désactiver l'oscillateur RO en fonction de l'état d'un signal de commande ENRO. Par exemple, ce circuit 202 comprend un transistor couplant à la masse GND la sortie de la porte INf, qui est connectée à l'entrée de la porte I1, ce transistor étant commandé par le signal ENRO. A titre d'exemple, le signal ENRO est fourni par un circuit de commande, par exemple par un circuit de commande 204 représenté sous la forme d'un bloc CMD en figure 2.

Dans un autre exemple non illustré, le circuit 202 est omis. La sortie de la porte INf est alors, par exemple, connectée à l'entrée de la porte In1.

Les portes logiques Ii fournissent des signaux de sortie respectifs CKfi (CKf1, CKf2, CKf3, ..., CKfNf-1, CKfNf en figure 2). Les signaux CKfi constituent des signaux d'horloge rapides. Les signaux d'horloge rapides CKfi ont, de manière similaire aux signaux d'horloge CK1 à CKN de la figure 1, des fronts présentant des décalages temporels les uns par rapport aux autres. Dans l'exemple de la figure 2, les fronts considérés sont des fronts montants. La personne du métier sera en mesure d'adapter la description au cas où les fronts considérés sont des fronts descendants.

Dans l'exemple de la figure 2, les portes logiques Ii sont, par exemple, des inverseurs. Il est toutefois possible que l'oscillateur RO soit formé à partir d'autres types de portes logiques Ii, tels que des portes Ii de type NON-OU ("NOR" en anglais) ou des portes Ii de type NON-ET ("NAND" en anglais).

Le dispositif 200 comprend en outre un registre à décalage OSC configuré en oscillateur. L'oscillateur OCS comprend un nombre Ns de bascules de type D ("D Flip-Flop" en anglais) FFsj (FFs1, FFs2, FFsNs-1 et FFsNs en figure 2), avec j un indice entier allant de 1 à Nf, et Nf un entier strictement supérieur ou égal à 1, par exemple supérieur ou égal à 3. Les bascules FFsj sont reliées en série, c'est à dire les unes à la suite des autres, par exemple par ordre d'indice j croissant en figure 2.

Par les termes « reliées en série » on entend que la sortie d'une bascule, notée Q, est reliée à l'entrée de donnée, notée D, de la bascule suivante dans la série. Dans l'exemple de la figure 2, la sortie Q d'une bascule est connectée à l'entrée de donnée D de la bascule suivante dans la série. Dans un autre exemple, chaque bascule a sa sortie Q reliée à l'entrée D de la bascule suivante par un circuit introduisant un retard, de sorte à éviter des problèmes de métastabilité dans le registre OSC.

Chaque bascule FFsj fournit sur sa sortie Q un signal CKsj (CKs1, CKs2, ..., CKsNs-2, CKsNS-1 et CKsNs en figure 2).

Chaque bascule FFsj a une entrée de synchronisation, notée CK en figure 2, recevant un même signal d'horloge CK1. Par exemple, le registre OSC à une entrée de synchronisation CKOSC configurée pour recevoir le signal CK1, l'entrée CKOSC étant couplée, de préférence connectée, à l'entrée CK de chaque bascule FFsj. Dans la suite de la description, des exemples sont décrits dans lesquels les bascules sont activées par des fronts montants. Cependant, la personne du métier saura adapter l'enseignement de la description pour des bascules à activation par front descendant. La personne du métier saura également adapter le circuit en considérant une sortie $\overline{\overline{Q}}$ des bascules, la sortie $\overline{\overline{Q}}$ d'une bascule correspondant au complément binaire de la sortie Q de cette bascule.

Selon un mode de réalisation, le signal CK1 correspond à un des signaux d'horloge rapides CKfi.

Par exemple, le dispositif 200 comprend un circuit de sélection MUX1, par exemple un multiplexeur, configuré pour recevoir tout ou partie des signaux CKfi et pour sélectionner, sur la base d'un signal de commande SEL1, le signal CK1 parmi les signaux CKfi reçus. A titre d'exemple, le signal SEL1 est fourni par un circuit de commande, par exemple le circuit 204.

A titre d'exemple alternatif, le circuit MUX1 est omis, et l'entrée CKOSC de l'oscillateur OSC est connectée à la sortie de la porte Ii fournissant le signal CKfi auquel correspond le signal CK1.

De préférence, le signal CK1 correspond au signal CKf1.

En outre, le registre à décalage OCS est rebouclé sur lui-même de sorte que ce dernier fonctionne comme un oscillateur. Plus particulièrement, le registre OSC est configuré pour émuler un oscillateur fonctionnant à une fréquence Fs = 1/(Tf*Ns), c'est à dire à une fréquence Ns fois plus lente que la fréquence de l'oscillateur RO. Ainsi, les signaux CKsj constituent des signaux d'horloge lents par rapport aux signaux d'horloge rapides CKfi.

Dans un exemple non illustré, la sortie Q de la bascule FFsNs est couplée à l'entrée D de la bascule FFs1 par un inverseur. Par exemple, cet inverseur reçoit le signal CKsNs et fournit un signal D1 qui est appliqué, c'est à dire fourni, à l'entrée D de la bascule FFs1.

Dans l'exemple de la figure 2, la sortie Q de la bascule FFsNs est fournie à un circuit de logique combinatoire C1, configuré pour fournir un signal D1 à l'entrée D de la bascule FFs1.

Plus particulièrement, dans l'exemple de la figure 2, le circuit C1 reçoit un signal ENOSC permettant de sélectivement activer et désactiver l'oscillateur OSC, et tout ou partie des signaux CKsj.

Par exemple, lorsque le niveau haut des signaux CKsj et ENOSC correspond à un '1' logique, le signal D1 est égal à un OU logique entre :

- le signal CKsNs ;
- une négation (ou complément) logique d'un OU logique des signaux CKsj des Ns-K dernières bascules de la série ; et

- une négation (ou complément) du signal ENOSC lorsque le signal ENOSC est configuré pour contrôler tous les signaux CKsj à '1' si ENOSC est à l'état bas correspondant au '0' logique.

A titre d'autre exemple, lorsque le niveau haut des signaux Cksj et ENOSC correspond à un '1' logique, le signal D1 est égal à un ET logique entre :

- le signal ENOSC ; et
- un OU logique entre :

   * le signal CKsNs ; et
   * une négation (ou complément) logique d'un OU logique des signaux CKsj des Ns-K dernières bascules de la série. Dans cet exemple, le signal ENOSC est configuré pour contrôler tous les signaux logique CKsj à '1' si ENOSC est à l'état bas correspondant au '0' logique.

Dans un autre exemple, le circuit C1 ne reçoit pas le signal ENOSC, et, lorsque le niveau haut des signaux CKsj correspond à un '1' logique, le signal D1 est égal à un OU logique entre :

- le signal CKsNs ;
- une négation (ou complément) logique d'un OU logique des signaux CKsj des Ns-K dernières bascules de la série.

Dans les trois derniers exemples décrits ci-dessus, K est un entier compris entre 1 et Ns-1 et les signaux CKsj ont un même rapport cyclique égal à K/Ns.

De façon similaire aux signaux d'horloge rapides CKj, les signaux d'horloge lents CKsj ont des fronts, par exemple montant dans l'exemple de la figure 2, qui sont décalés dans le temps. Le décalage entre deux fronts correspondants de deux signaux respectif CKsj et CKj+1 est égal à la période du signal CK1, c'est à dire à la période Tf de l'oscillateur RO. Par exemple, par rapport à un front du signal CKs1, le front correspondant du signal CKs2 est retardé d'une période du signal CK1, le front correspondant du signal CKs3 est retardé de deux périodes du signal CK1, etc.

Bien que cela ne soit pas représenté en figure 2, les entrées de remise à zéro ("reset" en anglais), notées R, des bascules FFsj reçoivent toutes un même signal de commande, par exemple fourni par un circuit de commande, par exemple par le circuit 204.

A titre d'exemple, lorsque l'oscillateur OSC est initialisé, ou remis à zéro, avant un front montant d'un des signaux CKfi ce front montant peut constituer l'instant initial d'un délai Dell à générer dans la séquence temporelle à produire. Par rapport à cet instant initial, en fonction du signal CKfi utilisé comme signal CK1, un front montant sur la sortie CKs1 de la bascule FF1 arrivera avec le délai, ou retard, Del11 égal à q*Tf/Nf, avec q un nombre entier compris entre 0 et Nf-1 et déterminé par le signal CKfi utilisé comme signal CK1. En outre, par rapport à ce front montant du signal CKs1, un front montant correspondant sur le signal CKsj arrivera avec un retard Del12 égal à (j-1)*Tf. Dit autrement, le choix du signal CK1 parmi les signaux CKfi et d'un des signaux de sortie CKsj permet de produire un délai Del1 ayant n'importe quelle valeur égale à Del11 + Del12, c'est à dire égale à q*Tf/Nf + (j-1)*Tf. En pratique le fonctionnement ci-dessus s'apparente au fonctionnement du dispositif de la figure 1.

Le dispositif 200 comprend en outre un registre à décalage SR. Ce registre à décalage est similaire au registre à décalage 110 de la figure 1, à la différence que son entrée de synchronisation CLKSR reçoit un signal d'horloge CKs correspondant à l'un des signaux d'horloge lent CKsj.

Par exemple, le dispositif 200 comprend un circuit de sélection MUX2, par exemple un multiplexeur, configuré pour recevoir tout ou partie des signaux CKsj et pour sélectionner, sur la base d'un signal de commande SEL2, le signal CKs parmi les signaux CKsj reçus. A titre d'exemple, le signal SEL2 est fourni par un circuit de commande, par exemple le circuit 204.

A titre d'exemple alternatif, le circuit MUX2 est omis, et l'entrée CKSR du registre SR est connectée à la sortie de la bascule FFsj fournissant le signal CKsj auquel correspond le signal CKs.

Le registre SR comprend un nombre Nd1 de bascules de type D FFl, avec l un indice entier allant de 1 à Nd1 et Nd1 un entier strictement positif. Dans l'exemple de la figure 2 Nd1 est strictement supérieur à 1 bien que dans d'autres exemple non illustrés, Nd1 puisse être égal à 1. Les bascules FFl (FF1, FF2, FFNd1-1, FFNd1 en figure 2) sont reliées en série, c'est à dire les unes à la suite des autres, par exemple par ordre d'indice l croissant en figure 2.

La définition des termes « reliées en série » donnée précédemment s'applique aux bascules FFl du registre à décalage SR. Dans l'exemple de la figure 2, chaque bascule FFl a sa sortie Q connectée à l'entrée D de la bascule suivante FFl+1 dans la série. Dans un autre exemple, chaque bascule FFl a sa sortie Q reliée à l'entrée D de la bascule FFl+1 suivante par un circuit introduisant un retard, de sorte à éviter des problèmes de métastabilité dans le registre à décalage SR.

Chaque bascule FFl fournit sur sa sortie Q un signal Ql (Q1, Q2, QNd1-2, QNd1-1 et QNd1 en figure 2).

Chaque bascule FFl à une entrée de synchronisation, notée CK en figure 2, recevant le signal d'horloge CKs. Par exemple, l'entrée CKSR est couplée, de préférence connectée, à l'entrée CK de chaque bascule FFl. Dans la suite de la description, des exemples sont décrits dans lesquels les bascules sont activées par des fronts montants. Cependant, la personne du métier saura adapter l'enseignement de la description pour des bascules à activation par front descendant. La personne du métier saura également adapter le circuit en considérant

une sortie $\overline{Q}$ des bascules, la sortie $\overline{Q}$ d'une bascule correspondant au complément binaire de la sortie Q de cette bascule.

L'entrée de donnée D de la première bascule FF1 de la série de bascules est, par exemple, alimentée par une tension à l'état haut, correspondant par exemple à un état logique '1', dans cet exemple où les fronts considérés sont des fronts montants.

Les entrées de remise à zéro, notées R, des bascules FFI reçoivent toutes un même signal de commande, par exemple fourni par un circuit de commande, par exemple par le circuit 204. Ce signal de commande est, par exemple, configuré pour que la remise à zéro des bascules FFI soit faite avant le commencement du cycle de génération de la séquence temporelle.

A titre d'exemple, lorsque le registre SR est, par exemple, initialisé, ou remis à zéro, avant un front montant d'un des signaux CKsj ce front montant peut constituer l'instant initial d'un délai Del2 à générer dans la séquence temporelle à produire. En fonction du signal CKsj utilisé comme signal CKs, par rapport à l'instant initial du délai Del2, un front montant sur la sortie Q1 de la bascule FF1 arrivera avec le délai, ou retard, Del21 égal à o*Ts/Ns = o*Tf, avec o un nombre entier compris entre 0 et Ns-1 et déterminé par le signal CKsj utilisé comme signal CKs. En outre, par rapport à ce front montant du signal Q1, un front montant correspondant sur le signal Qp, avec p un nombre entier allant de 1 à Nd1, arrivera avec un retard Del22 égal à (p-1)*Ts. Dit autrement, le choix du signal CKs parmi les signaux CKsj et d'un des signaux de sortie QI permet de produire un délai Del2 ayant n'importe quelle valeur égale à Del21 + Del22, c'est à dire à o*(Ts/Ns) + (p-1)*Ts.

A titre d'exemple complémentaire, il est possible de produire, par rapport à un instant initial correspondant à l'instant initial du délai Dell, un délai ou retard Del3 égal à la somme des délais Dell et Del2, par exemple en prévoyant que le délai Del2 débute à la fin du délai Dell. Le délai Del3 aura un pas de réglage égal à Tf/Ns.

Plus généralement, le dispositif 200 permet de produire des délais entre deux fronts d'une séquence temporelle à générer, en découpant d'abord un délai à produire en un nombre de périodes Ts de l'oscillateur OSC, puis en découpant une durée restante en un nombre de périodes Tf de l'oscillateur RO, puis en découpant une durée restante en un nombre de pas de réglage fin Tf/Nf. Dit autrement, un délai à produire peut être décomposé en une somme d'un nombre de périodes Ts, d'un nombre de périodes Tf et d'un nombre de pas de réglage fin Tf/Nf. Cela diffère du dispositif de la figure 1 où un délai à produire était décomposé uniquement une somme d'un nombre de périodes de l'oscillateur 102 (correspondant à l'oscillateur RO dans le dispositif de la figure 2) et d'un nombre de pas de réglage fin T/N (équivalent à Tf/Nf dans le dispositif de la figure 2).

En outre, pour générer un délai supérieur ou égal à 10 fois la période de l'oscillateur 102 de la figure 1, ou RO de la figure, le dispositif 200 a besoin d'un nombre réduit de bascules par rapport au dispositif de la figure 1, tout en conservant la même finesse de réglage, c'est à dire la même résolution temporelle. Le dispositif 200 a donc un encombrement plus faible qu'un dispositif 100 correspondant. De plus, du fait que les bascules des registres OSC et SR commutent à une fréquence plus faible que les bascules du dispositif 100, le dispositif 200 a également une consommation plus faible que celle d'un dispositif 100 équivalent.

A titre d'exemple comparatif, on considère un dispositif 100 dans lequel N = 5 et T = 1,25 ns. Dans ce cas, la résolution temporelle sur les délais générés avec le dispositif 100 est égale à T/N = 1,25/5 = 250 ps. Pour générer un délai de 12,5 ns, qui est donc égal à 10 fois la période T de l'oscillateur 100, le registre 110 devra comprendre une succession d'au moins dix bascules en série. On considère désormais le dispositif 200 de la figure 2, dans lequel Nf = 5 et Tf = 1,25 ns. Dans ce cas, comme pour le dispositif 100, la résolution temporelle sur les délais générés avec le dispositif 200 est égale à Tf/Nf = 250 ps. Toutefois, pour générer un délai de 12,5 ns dans le cas où, à titre d'exemple, le registre OSC a Ns = 5 bascules et fonctionne donc à une période Ts = Ns*Tf = 6,25 ns, il suffit de Nd1 = 2 bascules dans le registre SR. Le dispositif 200 peut alors comprendre 3 bascules de moins que le dispositif 100.

Le signal de sortie OUT1 du registre SR correspond à l'un des signaux de sortie QI des bascules FFI.

Dans l'exemple de la figure 2, les signaux QI de sortie des bascules FFI sont, par exemple, relié à un circuit de sélection MUX3, par exemple un multiplexeur. Le multiplexeur MUX3 est configuré pour sélectionner, sur la base d'un signal de commande SEL3, l'un des signaux QI qu'il reçoit pour former un signal de sortie OUT1 du registre à décalage SR. A titre d'exemple, le signal SEL2 est fourni par un circuit de commande, par exemple le circuit 204. La prévision du circuit MUX3 permet d'ajuster le délai se terminant avec un front sur le signal OUT1.

Dans d'autres exemples non illustrés, le circuit MUX3 est omis, et la sortie du registre SR sur laquelle est disponible le signal OUT1 est directement connectée à la sortie d'une des bascules FFI.

Dans le mode de réalisation de la figure 2, le dispositif 200 comprend en outre un registre à décalage SR'. Le registre à décalage SR' est synchronisé sur un signal d'horloge CKf correspondant à l'un des signaux d'horloge rapide CKfi. Une entrée de synchronisation CKSR' du registre SR' reçoit le signal CKf.

Par exemple, le dispositif 200 comprend un circuit de sélection MUX4, par exemple un multiplexeur, configuré pour recevoir tout ou partie des signaux CKfi et pour sélectionner, sur la base d'un signal de commande SEL4, le signal CKf parmi les signaux CKfi reçus. Le circuit MUX4 fournit le signal CKf sélectionné à l'entrée CKSR' du registre SR'. A titre d'exemple, le signal SEL4 est fourni par un circuit de commande, par exemple le circuit 204.

A titre d'exemple alternatif, le circuit MUX4 est omis, et l'entrée CKSR' du registre SR' est connectée à la sortie de la porte Ii fournissant le signal CKfi auquel correspond le signal CKf.

Le registre à décalage SR' comprend un nombre Nd2 de bascules de type D FF'u, avec u un indice entier allant de 1 à Nd2 et Nd2 un entier strictement positif. Dans l'exemple de la figure 2 Nd2 est strictement supérieur à 1 bien que dans d'autres exemple non illustrés, Nd2 puisse être égal à 1. Les bascules FF'u (FF'1, FF'2, FF'Nd2-1, FF'Nd2 en figure 2) sont reliées en série, c'est à dire les unes à la suite des autres, par exemple par ordre d'indice u croissant en figure 2.

La définition des termes « reliées en série » donnée précédemment s'applique aux bascules FF'u du registre à décalage SR'. Dans l'exemple de la figure 2, chaque bascule FF'u a sa sortie Q connectée à l'entrée D de la bascule suivante FF'u+1 dans la série. Dans un autre exemple, chaque bascule FF'u a sa sortie Q reliée à l'entrée D de la bascule FF'u+1 suivante par un circuit introduisant un retard, de sorte à éviter des problèmes de métastabilité dans le registre à décalage SR'.

Chaque bascule FF'u fournit sur sa sortie Q un signal Q'u (Q'1, Q'2, Q'Nd2-1 et Q'Nd2 en figure 2).

Chaque bascule FF'u a une entrée de synchronisation, notée CK en figure 2, recevant le signal d'horloge CKf. Par exemple, l'entrée CKSR' est couplée, de préférence connectée, à l'entrée CK de chaque bascule FF'u. Dans la suite de la description, des exemples sont décrits dans lesquels les bascules sont activées par des fronts montants. Cependant, la personne du métier saura adapter l'enseignement de la description pour des bascules à activation par front descendant. La personne du métier saura également adapter le circuit en considérant une sortie $\overline{Q}$ des bascules, la sortie $\overline{Q}$ d'une bascule correspondant au complément binaire de la sortie Q de cette bascule.

L'entrée de donnée D de la première bascule FF'1 de la série de bascules FF'u est couplée, par exemple connectée, à une entrée de donnée DSR' du registre RS', l'entrée DSR' recevant le signal de sortie OUT1 du registre SR. Dans l'exemple de la figure 2, l'entrée D de la bascule FF'1 est connectée l'entrée DSR' du registre, et reçoit donc le signal OUT1.

Les entrées de remise à zéro, notées R, des bascules FF'u reçoivent toutes un même signal de commande, par exemple fourni par un circuit de commande, par exemple par le circuit 204.

Le registre SR' fournit un signal de sortie OUT2, correspondant par exemple à un signal de sortie du dispositif 200.

A titre d'exemple, le registre SR' est configuré pour générer un front sur le signal OUT2 du registre avec un retard Del4 par rapport à un front sur le signal OUT1 de sortie du registre SR, ce front sur la sortie OUT1 constituant l'instant initial du délai Del4. A titre d'exemple, le registre SR' est réinitialisé avant cet instant initial du délai Del4. L'instant initial du délai Del4 est synchronisé sur le signal CKs lui-même synchronisé sur le signal CK1 correspondant à l'un des signaux CKfi. Dans cet exemple, en fonction du signal CKfi utilisé comme signal CKf, un front montant sur la sortie Q'1 de la bascule FF'1 arrivera avec un délai, ou retard, Del41 égal à k*Tf/Nf, avec k un nombre entier compris entre 0 et Nf-1 et déterminé par les signaux CKfi utilisés comme signaux respectifs CK1 et CKs. En outre, par rapport à ce front montant du signal Q'1, un front montant correspondant sur le signal Q'u arrivera avec un retard Del42 égal à (u-1)*Tf. Dit autrement, le choix du signal CKf parmi les signaux CKfi et d'un des signaux de sortie Q'u comme signal OUT2 permet de produire un délai Del4 ayant n'importe quelle valeur égale à Del41 + Del42, c'est à dire égal à k*Tf/Nf + (u-1)*Tf.

En pratique, le fonctionnement ci-dessus du registre SR' pour générer un délai Del4 entre un front sur le signal OUT1 et un front sur le signal OUT2 s'apparente au fonctionnement du registre 122 du dispositif de la figure 1 pour générer un délai entre un front sur la sortie SR1_OUTPUT du registre 104 et un front sur une sortie d'un autre registre à décalage faisant partie du circuit 122. La méthodologie décrite dans les demandes de brevet FR 3133458, US 2023291396 et CN 116760392 s'applique pour sélectionner le signal Ckf parmi les signaux CKfi et un signal de sortie OUT2 parmi les signaux Q'u de sorte à mettre en œuvre un délai Del4 entre un front sur le signal OUT1 et un front sur le signal OUT2. Notamment, la personne du métier saura en mesure d'éviter les éventuels problèmes de métastabilité, par exemple en choisissant le signal CKf en s'appuyant sur la méthode décrite en relation avec les figures 4, 5a, 5b et 5c des demandes susmentionnées.

Dans l'exemple de la figure 2, les signaux Q'u de sortie des bascules FF'u sont, par exemple, relié à un circuit de sélection MUX5, par exemple un multiplexeur. Le multiplexeur MUX5 est configuré pour sélectionner, sur la base d'un signal de commande SEL5, l'un des signaux Q'u qu'il reçoit pour former le signal de sortie OUT2 du registre à décalage SR'. A titre d'exemple, le signal SEL5 est fourni par un circuit de commande, par exemple le circuit 204. La prévision du circuit MUX5 permet d'ajuster le délai se terminant avec un front sur le signal OUT2.

Dans d'autres exemples non illustrés, le circuit MUX5 est omis, et la sortie du registre SR' sur laquelle est disponible le signal OUT2 est directement connectée à la sortie d'une des bascules FF'u.

En reprenant l'exemple de calcul des délais Del1 et Del3, lorsque l'instant initial du délai Del1 est synchronisé sur un front du signal CK1, le délai Del11 a une valeur nulle, et que le délai Del1 a alors valeur égale à 0 + Del12, c'est à dire égale à (j-1)*Tf. Il en résulte que le délai Del3 a une résolution temporelle égale à Tf, et non plus à Tf/Nf. La prévision du registre SR' permet alors de générer un délai Del3' entre l'instant initial du délai Dell et un front sur la sortie OUT2 marquant la fin du délai Del3', qui a une valeur égale à Del3 + Del4 et qui a donc une résolution temporelle égal à Tf/Nf.

A titre d'exemple comparatif, on considère un dispositif 100 dans lequel N = 5 et T = 1,25 ns. Pour générer un délai de 12,5 ns, qui est donc égal à 10 fois la période T de l'oscillateur 100, le registre 110 devra comprendre une succession d'au moins dix bascules en série. On considère désormais le dispositif 200 de la figure 2, dans lequel Nf = 5, Tf = 1,25 ns, Ns = 5, CK1=CKf1 et CKs=CKs5. Dans ce cas, il suffit que Nd1 soit égal à 2, que Nd2 soit égal à 1, que OUT1=Q2, que CKf=CK4 et que OUT2=Q'1 pour générer un délai de 12,5 ns entre un front du signal CK1 et un front du signal OUT2, avec une résolution de Tf/Nf. Le dispositif 200 peut alors comprendre 2 bascules de moins que le dispositif 100.

On a décrit ci-dessus des exemples de modes de réalisation dans lequel le registre SR' est synchronisé sur un signal CKf correspondant à un des signaux d'horloge rapides CKfi. Dans d'autres modes de réalisation, le registre SR' peut être synchronisé sur un signal d'horloge correspondant à un des signaux d'horloge lents CKsj.

Par ailleurs, des séquences temporelles comprenant plus de fronts peuvent être produite en ajoutant des registres à décalage les uns à la suite des autres de la même façon que le registre SR' est à la suite du registre SR, chacun de ces registres supplémentaires étant synchronisé sur un signal d'horloge respectif correspondant à un des signaux d'horloge lents CKsj ou à un des signaux d'horloge rapides CKfi.

Par ailleurs, on a décrit ci-dessus des exemples de modes de réalisation dans lesquelles le signal CK1 correspond à l'un des signaux d'horloge rapides CKfi. Dans des variantes de réalisation, pour générer des délais plus longs dans une séquence temporelle, il est prévu que le signal CK1 corresponde à l'un des signaux CKfi ayant vu préalablement sa fréquence divisée par un nombre M entier positif. En effet, dans ce cas, la période de l'oscillateur OSC est multipliée par M. On notera que le cas M égal à 1 revient à ce que le signal CK1 corresponde à l'un des signaux d'horloge rapides CKfi, comme c'est le cas des exemples précédemment décrits.

Par ailleurs, comme cela a été indiqué précédemment, bien que les exemples de séquences et de délais produits avec le dispositif 200 ait été décrits en référence à des fronts montants, la personne du métier sera en mesure, à partir de la présente description, de produire avec le dispositif 200 des délais et/ou des séquences temporelles entre des fronts montants et des fronts descendants, ou entre des fronts descendants uniquement. Par exemple, dans le cas où le front d'intérêt généré en sortie OUT1 du registre SR est un front descendant, la première bascule FF1 du registre SR peut avoir son entrée de donnée D recevant une tension à l'état bas, correspondant par exemple à un état logique '0'.

En particulier, bien que cela n'ait pas été indiqué en relation avec la description faite précédemment de l'oscillateur OSC, la prévision d'un rapport cyclique K/Ns donné présente un intérêt lorsque la séquence temporelle produite par le dispositif 200 est une séquence entre des fronts montants et des fronts descendants, ce qui est, par exemple le cas lorsque la séquence produite est une séquence de commande d'un dispositif de puissance configuré pour fournir une puissance moyenne égale à une valeur de consigne.

A titre d'exemple, le dispositif 200 peut être utilisé pour produire des séquences de commande de dispositif de puissance ou de mémoires, par exemple dans des systèmes électroniques correspondant à des applications de puissance, par exemple industrielles, et/ou à des applications du domaine des transports, et/ou à des applications de type internet des objets (IoT de l'anglais "Internet of Things").

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les signaux générés en sortie d'un ou plusieurs registres commandés par les oscillateurs RO et OSC dans le dispositif 200 peuvent être recombinés avec des portes logiques pour construire des signaux plus complexes. En outre, dans des exemples non illustrés, le circuit MUX1 peut ne recevoir qu'une partie seulement des signaux CKfi et/ou le circuit MUX2 peut ne recevoir qu'une partie seulement des signaux CKsj et/ou le circuit MUX3 peut ne recevoir qu'une partie seulement des signaux Ql et/ou le circuit MUX4 peut ne recevoir qu'une partie seulement des signaux CKfi et/ou le circuit MUX5 peut ne recevoir qu'une partie seulement des signaux Q'u. A l'inverse, dans d'autres exemples, le circuit MUX2 peut recevoir, en plus d'un ou plusieurs signaux CKsj, toute ou partie des signaux Ckfi et/ou le circuit MUX4 peut recevoir, en plus d'un ou plusieurs signaux CKfi, toute ou partie des signaux CKsj. Dit autrement, dans ces autres exemples, le signal CKs est sélectionné parmi toute ou partie des signaux CKfi et toute ou partie des signaux CKsj, et/ou le signal CKf est sélectionné parmi toute ou partie des signaux CKfi et toute ou partie des signaux CKsj.

Enfin, la mise en œuvre pratique des modes de réalisation et variantes décrits est à la portée de la personne du métier à partir des indications fonctionnelles données ci-dessus. En particulier, la personne du métier sera en mesure, à partir de la description fonctionnelle faite ci-dessus, de mettre en œuvre les étapes de réinitialisation des oscillateurs RO et OSC et des registres SR et SR' en fonction d'une séquence temporelle à générer, pour obtenir le fonctionnement décrit précédemment, à savoir la génération d'un délai décomposé en un nombre de périodes Ts, un nombre de périodes Tf, et un nombre de pas Tf/Nf. A titre d'exemple, ces réinitialisations des différents éléments RO, OSC, SR et SR' du dispositif sont commandés par le circuit 204.

**Revendications**

1. Dispositif (200) comprenant :

   un oscillateur en anneau (RO) comprenant une pluralité de portes logiques inverseuses (I1, INf) couplées les unes à la suite des autres et fournissant chacune un signal d'horloge rapide (CKf1, CkfNf) ;
   un premier registre à décalage (OSC) comprenant une succession de premières bascules (FFs1, FFsNS), de préférence de type D, synchronisées chacune sur un même premier signal d'horloge (CK1) correspondant à un des signaux d'horloge rapides (CKf1, CkfNf) ayant sa fréquence divisée par un entier M strictement positif, le premier registre à décalage (OSC) étant rebouclé sur lui-même de sorte à mettre en œuvre un deuxième oscillateur dans lequel chaque première bascule (FFs1, FFsNs) fournit un signal d'horloge lent (CKs1, CKsNs) ; et
   un deuxième registre à décalage (SR) comprenant une unique deuxième bascule ou une succession de deuxièmes bascules (FF1, FFNd1), chaque deuxième bascule étant synchronisée sur un même deuxième signal d'horloge (CKs) correspondant à l'un des signaux d'horloge lents (CKs1, CKsNs).

2. Dispositif selon la revendication 1, dans lequel une entrée de donnée (D) d'une première première bascule (FFs1) de ladite succession de premières bascules reçoit un signal (D1) déterminé au moins en partie par un premier signal binaire égal à un OU logique entre une sortie d'une dernière première bascule (FFsNs) de ladite succession de premières bascules et une négation logique d'un OU logique entre des sorties d'au moins deux dernières premières bascules de ladite succession de premières bascules.

3. Dispositif selon la revendication 2, dans lequel le signal (D1) reçu par l'entrée de donnée de la première première bascule est égal à un OU logique entre le premier signal et une négation d'un signal d'activation (ENOSC), ou à un ET logique entre le premier signal et le signal d'activation (ENOSC).

4. Dispositif selon l'une quelconque des revendications 1 à 3, dans lequel les signaux d'horloge rapides (CKf1, CKfNf) sont décalés en temps les uns par rapport aux autres.

5. Dispositif selon l'une quelconque des revendications 1 à 4, dans lequel les signaux d'horloge lents (CKs1, CKsNs) sont décalés en temps les uns par rapport aux autres.

6. Dispositif selon l'une quelconque des revendications 1 à 5, dans lequel le dispositif (200) comprend un premier circuit de sélection (MUX1) configuré pour sélectionner le premier signal d'horloge (CK1) parmi ledit signal d'horloge rapide ayant sa fréquence divisée par l'entier M et au moins un autre des signaux d'horloge rapides (CKf1, CKfNf).

7. Dispositif selon la revendication 6, dans lequel le premier circuit de sélection (MUX1) est configuré pour fournir le premier signal d'horloge (CK1) à une entrée de synchronisation (CK) de chacune des premières bascules (FFs1, FFsNs).

8. Dispositif selon l'une quelconque des revendications 1 à 7, dans lequel le dispositif (200) comprend un deuxième circuit de sélection (MUX2) configuré pour sélectionner le deuxième signal d'horloge (CKs) parmi tout ou partie des signaux d'horloge lents (CKs1, CKsNs).

9. Dispositif selon la revendication 8, dans lequel le deuxième circuit de sélection (MUX2) est configuré pour fournir le deuxième signal d'horloge (CKs) à une entrée de synchronisation (CK) de chacune des deuxièmes bascules (FF1, FFNd1).

10. Dispositif selon l'une quelconque des revendications 1 à 9, dans lequel le dispositif (200) comprend un troisième registre à décalage (SR') comprenant une unique troisième bascule ou une succession de troisièmes bascules (FF'1, FF'Nd2), de préférence de type D, chaque troisième bascule étant synchronisée sur un même troisième signal d'horloge (CKf) correspondant à un des signaux d'horloge rapides (CKf1, CKfNf).

11. Dispositif selon la revendication 10, dans lequel le dispositif comprend un troisième circuit de sélection (MUX4) configuré pour recevoir tout ou partie des signaux d'horloge rapides (CKf1, CKfNf), et pour fournir le troisième signal d'horloge (CKf) à une entrée de synchronisation (CK) de chaque troisième bascule (FF'1, FF'Nd2).

12. Dispositif selon la revendication 10 ou 11, dans lequel une entrée de donnée (DSR') du troisième registre à décalage (SR') reçoit un signal déterminé par une sortie (OUT1) du deuxième registre à décalage (SR).

13. Dispositif selon la revendication 12, dans lequel le deuxième registre à décalage (SR) comprend la succession de deuxièmes bascules (FF1, FFNd1), et le dispositif (200) comprend un quatrième circuit de sélection (MUX3) configuré pour sélectionner un signal de sortie (Q1, QNd1) d'une des deuxièmes bascules (FF1, FFNd1) parmi tout ou partie des signaux de sortie des deuxièmes bascules, et pour fournir le signal sélectionné (OUT1) à l'entrée de donnée (DSR') du troisième registre à décalage (SR').

14. Dispositif selon l'une quelconque des revendications 10 à 13, dans lequel une sortie (OUT2) du troisième registre (SR') est une sortie (Q'1, Q'Nd2) de l'unique troisième bascule ou d'une des troisièmes bascules (FF'1, FF'Nd2) de la succession de troisièmes bascules, par exemple, sélectionnée par un circuit de sélection (MUX5) parmi tout ou partie des sorties (Q'1, Q'Nd2) des troisièmes bascules (FF'1, FF'Nd2) de la succession de troisièmes bascules.

15. Dispositif selon l'une quelconque des revendications 1 à 14, dans lequel le dispositif comprend un circuit (204) configuré pour :

commander des initialisations des bascules (FFs1, FFsNs ; FF1, FFNd1 ; FF'1, FF'Nd2) ; et/ou commander une activation (ENRO) du premier oscillateur (R0).

Fig 1

Fig 2

EP 4 648 283 A1

14

Europäisches
Patentamt

European
Patent Office

Office européen
des brevets

**RAPPORT DE RECHERCHE EUROPEENNE**

Numéro de la demande

EP 25 17 2692

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 6 369 624 B1 (WANG BONNIE I [US] ET AL) 9 avril 2002 (2002-04-09) | 1,4-7, 10,12, 14,15 | INV. H03K5/135 H03K5/15 |
| Y | * colonne 10, lignes 10-37; figure 12 * | 2,3 | |
| A | * colonne 12, ligne 29 - colonne 13, ligne 9; figure 16A * * colonne 13, lignes 49-67; figure 19 * ----- | 8,9,11, 13 | ADD. H03K3/03 |
| X | US 8 456 203 B2 (KONDOU MASAFUMI [JP]; FUJITSU LTD [JP]) 4 juin 2013 (2013-06-04) | 1,4-7,15 | |
| A | * colonne 6, ligne 56 - colonne 7, ligne 27; figure 6 * * colonne 9, lignes 1-29,44-57; figures 4,9 * ----- | 2,3,8-14 | |
| Y | US 2010/201409 A1 (TERADA SATOSHI [US] ET AL) 12 août 2010 (2010-08-12) * alinéas [0006], [0012] - [0014]; figures 1,2 * ----- | 2,3 | |

DOMAINES TECHNIQUES RECHERCHES (IPC)

H03K

Le présent rapport a été établi pour toutes les revendications

| Lieu de la recherche | Date d'achèvement de la recherche | Examinateur |
|---|---|---|
| Munich | 17 septembre 2025 | Martínez Martínez, J |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

.............................................................................................
& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 25 17 2692

La présente annexe indique les membres de la famille de brevets relatifs aux documents  brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

17-09-2025

| Document brevet cité au rapport de recherche | | Date de publication | Membre(s) de la famille de brevet(s) | | Date de publication |
|---|---|---|---|---|---|
| US 6369624 | B1 | 09-04-2002 | US | 6369624 B1 | 09-04-2002 |
| | | | US | 6667641 B1 | 23-12-2003 |
| US 8456203 | B2 | 04-06-2013 | JP | 5494370 B2 | 14-05-2014 |
| | | | JP | 2012060319 A | 22-03-2012 |
| | | | US | 2012056644 A1 | 08-03-2012 |
| US 2010201409 | A1 | 12-08-2010 | JP | 2010187356 A | 26-08-2010 |
| | | | US | 2010201409 A1 | 12-08-2010 |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 3133458
- US 2023291396 A

- CN 116760392